Europäisches Patentamt

European Patent Office

Office européen des brevets

(11) Veröffentlichungsnummer: **0 344 515**
**A2**

(12) # EUROPÄISCHE PATENTANMELDUNG

(21) Anmeldenummer: **89108869.2**

(22) Anmeldetag: **17.05.89**

(51) Int. Cl.⁴: **H01J 37/09 , H01J 9/02**

(30) Priorität: **31.05.88 DE 3818536**

(43) Veröffentlichungstag der Anmeldung:
**06.12.89 Patentblatt 89/49**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Lischke, Burkhard, Prof. Dr.**
**In der Heuluss 13**
**D-8000 München 82(DE)**
Erfinder: **Benecke, Wolfgang, Dr.**
**Sigismundstrasse 5**
**D-1000 Berlin 30(DE)**
Erfinder: **Schnakenberg, Uwe**
**Birkenstrasse 10**
**D-1000 Berlin 21(DE)**

(54) **Verfahren zur Herstellung einer Strahlformblende für ein Lithographiegerät.**

(57) Die mit einem erfindungsgemäßen Verfahren hergestellte Strahlformblende besteht im wesentlichen aus einem Halbleiterkörper (1), auf dessen Oberfläche eine Siliziumschicht (2) epitaktisch abgeschieden wurde. Die im mittleren Bereich als freitragende Membran ausgebildete Epitaxieschicht (2) besitzt eine vorzugsweise zeilenförmige Anordnung quadratischer Ausnehmungen (14) mit senkrechten Begrenzungsflächen. Im Prozeß zur Herstellung der Formstrahlblende kommen photolithographische Verfahren und galvanische Abformtechniken zur Anwendung. Die Strahlformblende kann auch in niedrig dotierten Epitaxieschichten durch Anwendung elektrochemischer Ätzverfahren erzeugt werden.

FIG 1

EP 0 344 515 A2

## Verfahren zur Herstellung einer Strahlformblende für ein Lithographiegerät.

Die Erfindung bezieht sich auf ein Verfahren zur Herstellung einer Strahlformblende für ein Lithographiegerät nach dem Oberbegriff des Patentanspruchs 1.

Aus der US-A-4 724 328 ist ein Lithographiegerät (Elektronenstrahlschreiber) bekannt, dessen elektronenoptische Säule eine Aperturblende zur Erzeugung einer Vielzahl individuell ablenkbarer Elektronensonden aufweist. Die in der EP-O 191 439 Al näher beschriebene Aperturblende besteht aus einer mit einer zeilenförmigen Mehrlochstruktur versehenen Siliziummembran, auf deren Oberfläche ein als Ablenkeinheit wirkendes Elektrodensystem angeordnet ist.

Der Erfindung liegt die Aufgabe zugrunde, ein Verfahren zur Herstellung einer Strahlformblende für ein Lithographiegerät anzugeben, wobei die mit einem primären Teilchenstrahl beaufschlagte Blende eine Halbleitermembran mit Ausnehmungen zur Erzeugung einer Vielzahl von Teilchensonden aufweist. Diese Aufgabe wird erfindungsgemäß durch die Verfahren nach den Patentansprüchen 1, 2 und 3 gelöst. Die Unteransprüche betreffen vorteilhafte Weiterbildungen der erfindungsgemäßen Verfahren.

Der mit der Erfindung erzielbare Vorteil besteht insbesondere darin, daß die den Strahlquerschnitt der Teilchensonden definierenden Ausnehmungen mit hoher Genauigkeit erzeugt werden können.

Die Erfindung wird im folgenden anhand der Zeichnungen näher erläutert. Hierbei zeigt

Figur 1 den schematischen Aufbau der herzustellenden Strahlformblende,

Figur 2 bis 4 verschiedene Prozeßfolgen zur Herstellung der Strahlformblende.

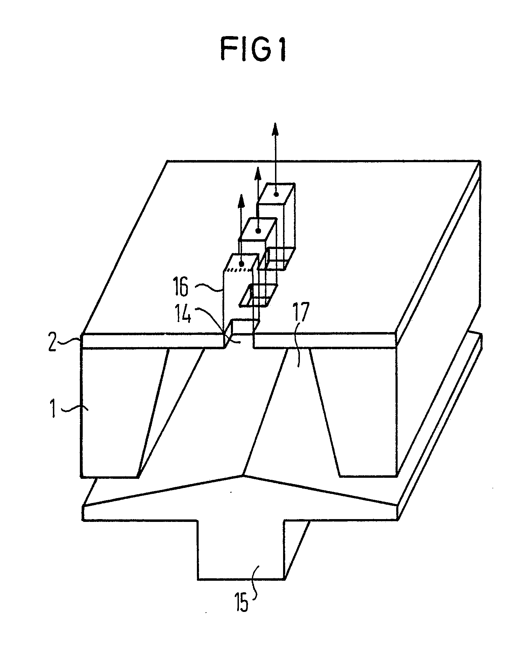

Die in Figur 1 schematisch dargestellte Strahlformblende für einen Elektronen- oder Ionenstrahlschreiber besteht im wesentlichen aus einem Halbleiterkörper 1, auf dessen Oberfläche eine Siliziumschicht 2 epitaktisch abgeschieden wurde. Die im mittleren Bereich als freitragende Membran ausgebildete Epitaxieschicht 2 besitzt eine vorzugsweise zeilenförmige Anordnung quadratischer Ausnehmungen 14 mit senkrechten Begrenzungsflächen. Wird diese Membran mit einem primären Teilchenstrahl 15 beaufschlagt, so erhält man auf der der Teilchenquelle abgewandten Seite eine Vielzahl von Teilchensonden 16, deren Strahlquerschnitt durch die Geometrie der Ausnehmungen 14 vorgegeben ist. Die Teilchensonden 16 können anschließend unter Verwendung der bekannten Aperturblende individuell abgelenkt bzw. ausgetastet und mit Hilfe einer teilchenoptischen Einheit auf das zu strukturierende Objekt abgebildet werden.

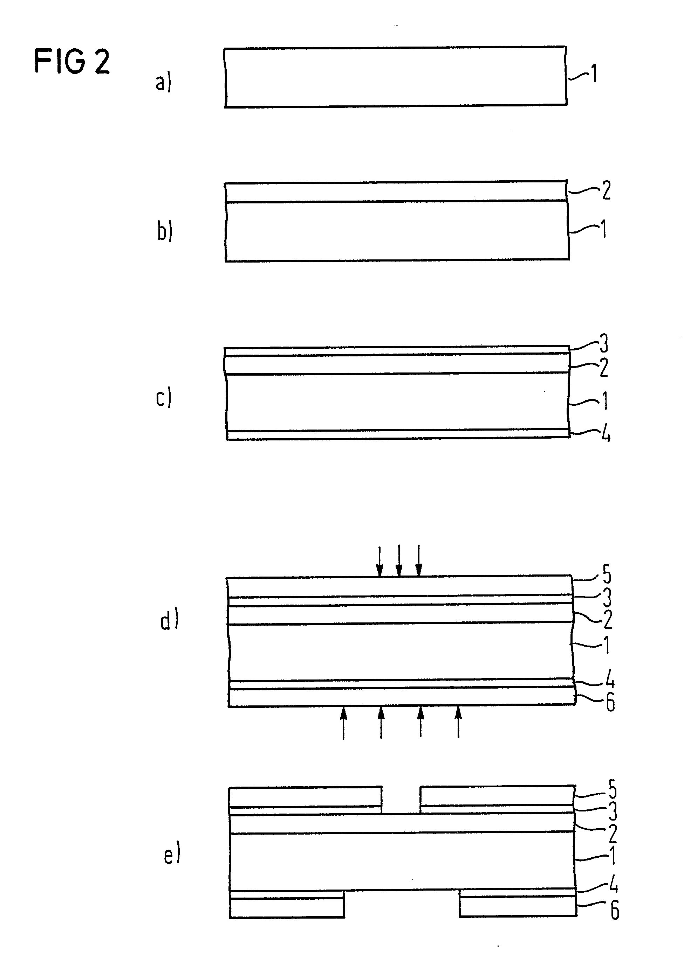

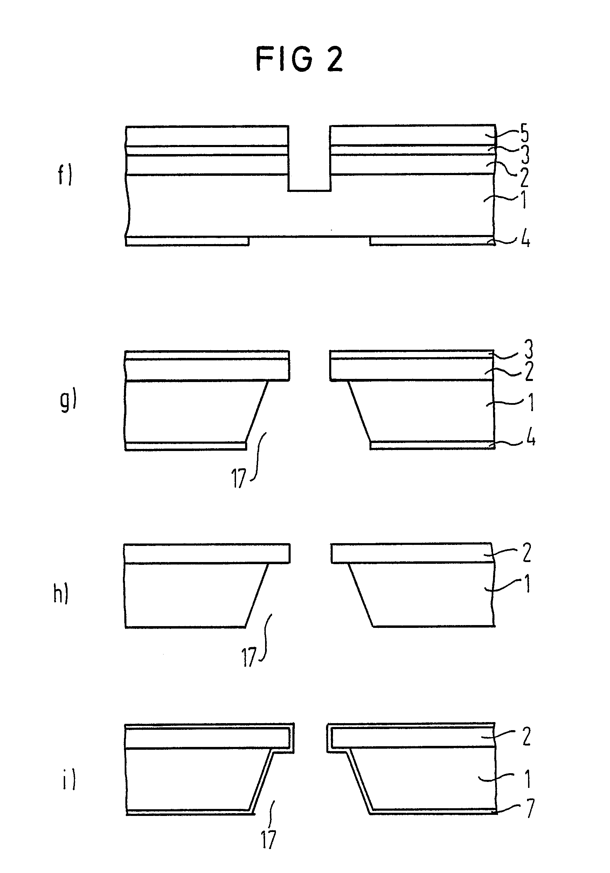

Der Prozeß zur Herstellung einer solchen Strahlformblende umfaßt erfindungsgemäß die folgenden Verfahrensschritte (siehe Figur 2):

- Epitaktische Abscheidung einer Halbleiterschicht 2, beispielsweise einer Siliziumschicht, auf einem Halbleitersubstrat 1 eines ersten Leitfähigkeitstyps, beispielsweise p-dotiertes Silizium mit (1, 0, 0)- oder (1, 1, 0)-Orientierung (Figur 2a, b).

- Dotierung der Epitaxieschicht 2 mit Bor (Schutz der Epitaxieschicht 2 während späterer Ätzprozesse) und Germanium (Minderung der mechanischen Spannungen), wobei die Borkonzentration $1 \times 10^{20}$ Boratome/cm$^3$ übersteigen sollte (die Dotierung wird vorzugsweise während der epitaktischen Abscheidung vorgenommen).

- Beschichtung der Wafervorderseite (Epitaxieschicht 2) und der Waferrückseite (Halbleitersubstrat 1) mit einem Dielektrikum 3 bzw. 4, beispielsweise Siliziumnitrid oder Siliziumoxid (Figur 2c).

- Lithographische Übertragung der Geometrie und Anordnung der Ausnehmungen 14 und der im Halbleitersubstrat 1 zu erzeugenden Durchgangsöffnung 17 auf die auf die Wafervorderseite bzw. Waferrückseite aufgeschleuderten Photolackschichten 5 bzw. 6 (Figur 2d).

- Reaktives Trockenätzen der dieleketrischen Schichten 2 und 4 (Strukturierung der Schichten 3 bzw. 4, Figur 2e).

- Reaktives Trockenätzen, insbesondere reaktives Ionenstrahlätzen der Epitaxieschicht 2 (Durchstossen der Epitaxieschicht; Figur 2f).

- Naßchemisches anisotropes Ätzen des Halbleitersubstrats 1 auf der Waferrückseite (Figur 2g).

- Entfernen der dielektrischen Schichten 3 und 4 (Figur 2h).

- Beschichtung der Epitaxieschicht 2 und des Halbleitersubstrats 1 mit einem Metall 6, beispielsweise Gold (Figur 2e).

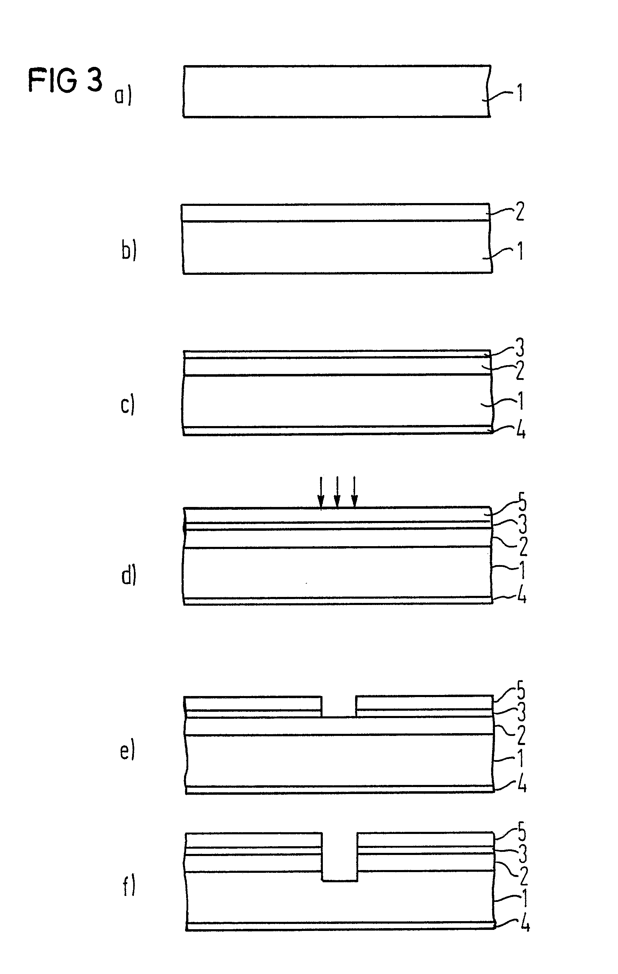

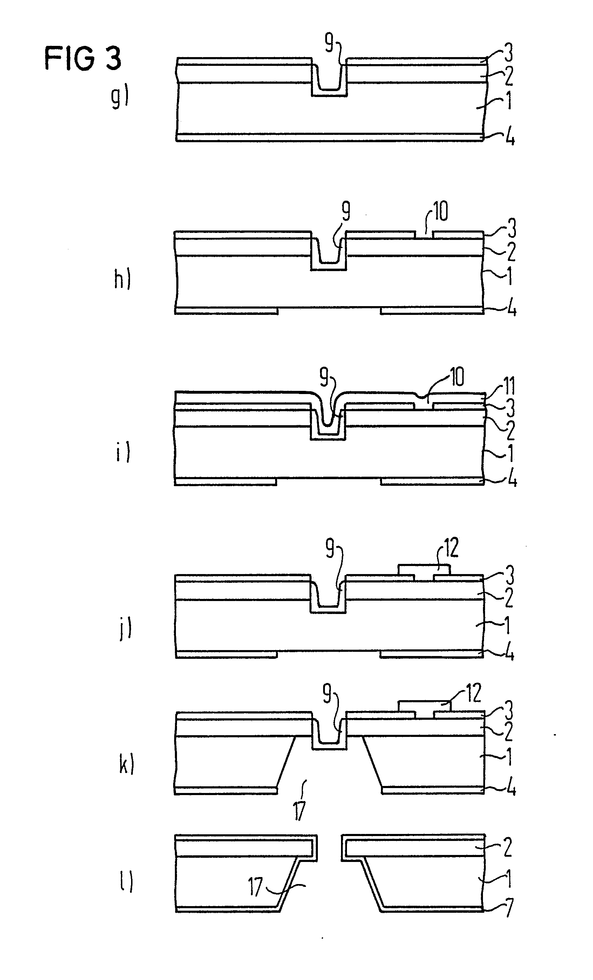

Gemäß weiterer Erfindung kann die in Figur 1 schematisch dargestellte Strahlformblende auch in niedrig dotierten Epitaxie-oder Diffusionsschichten unter Anwendung elektrochemischer Ätzverfahren erzeugt werden. Der Herstellungsprozeß umfaßt dann die folgenden Verfahrensschritte (siehe Figur 3):

- Epitaktische Abscheidung einer n-dotierten Siliziumschicht 2 auf einem Halbleitersubstrat 1, beispielsweise p-dotiertes Silizium (1, 0, 0)- oder (1, 1, 0)-Orientierung (Figur 3a, b).

- Beschichtung der Wafervorderseite (Epitaxieschicht 2) und der Waferrückseite (Halbleitersubstrat 1) mit einem Dielektrikum 3 bzw. 4, beispielsweise Siliziumnitrid oder Siliziumoxid (Figur 3c).

- Lithographische Übertragung der Geometrie und Anordnung der Ausnehmungen 14 auf eine auf die dielektrische Schicht 3 aufgeschleuderte Photolackschicht 5 (Figur 3d).
- Reaktives Trockenätzen der dielektrischen Schicht 3, (Strukturierung der dielektrischen Schicht 3; Figur 3e).
- Anisotropes Trockenätzen der Epitaxieschicht 2 (Durchstossen der Epitaxieschicht 2; Figur 3f).
- Entfernen der Photolackschicht 5 und Abscheidung einer Passivierungsschicht 9 innerhalb der Ätzgruben bzw. Oxidation der durch den Ätzprozeß freigelegten Flächen (Figur 3g).
- Lithographische Erzeugung eines Kontaktfensters 10 in der dielektrischen Schicht 3 (Figur 3h).
- Lithographische Übertragung der Geometrie der Substratdurchgangsöffnung 17 auf eine auf die dielektrische Schicht 4 aufgeschleuderte Photolackschicht und Strukturierung der Schicht 4 (Figur 3h).
- Metallisierung der Wafervorderseite, beispielsweise mit einer Haftschicht aus Chrom oder Titan und einer Goldschicht 11 (Figur 3i).
- Lithographische Strukturierung der Metallisierung 11 zur Erzeugung eines elektrischen Kontaktes 12 (Figur 3j).
- Anisotropes Ätzes des Halbleitersubstrats 1, beispielsweise in KOH, unter Verwendung eines elektrochemischen Ätzstops, wobei die Epitaxieschicht 2 über den Kontakt 12 mit dem positiven Pol einer Spannungsquelle verbunden ist (Figur 3k).
- Entfernen des Kontaktes 12 und der dielektrischen Schich ten 3, 4 und 9.
- Beschichtung des Substrats 1 und der Epitaxieschicht 2 mit einem Metall 7, beispielsweise Gold (Figur 3l).

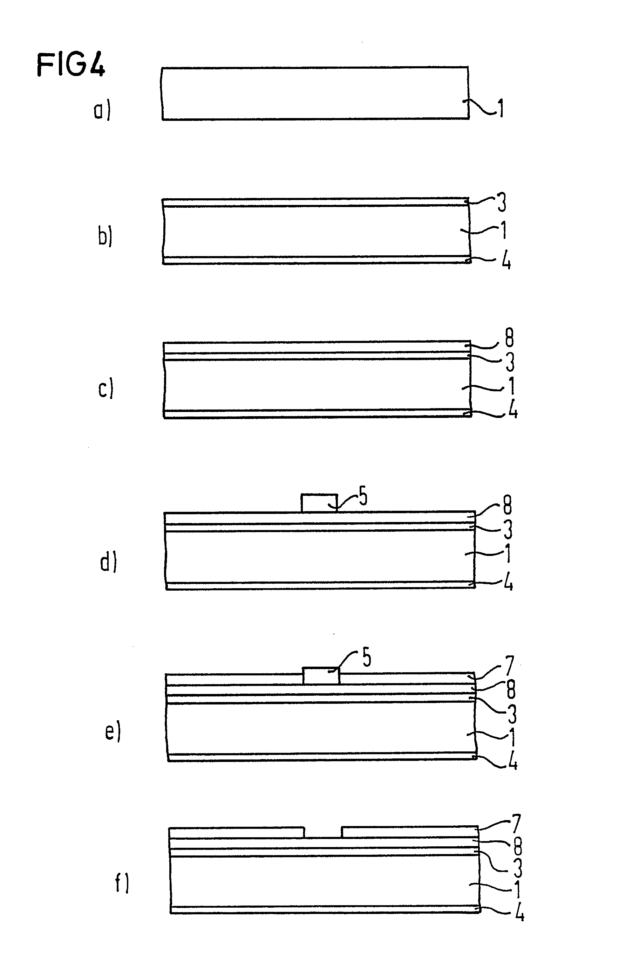

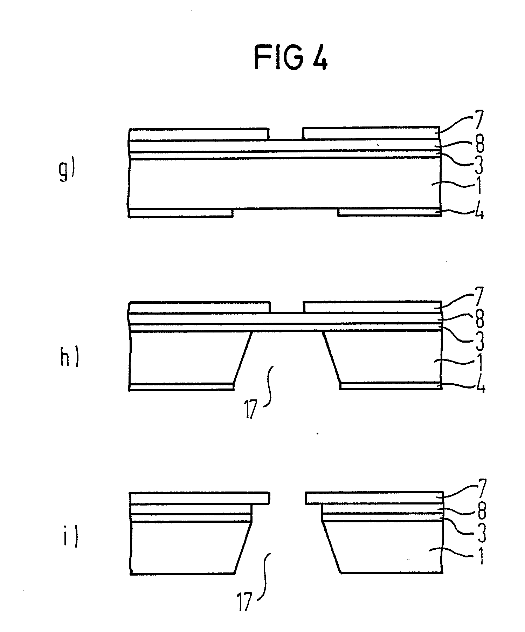

Gemäß weiterer Erfindung kann die Strahlformblende auch durch Anwendung lithographischer Verfahren und galvanische Abformung erzeugt werden. Der Herstellungsprozeß umfaßt dann die folgenden Verfahrensschritte (siehe Figur 4):
- Beidseitiges Beschichten eines Halbleitersubstrats 1, beispielsweise Silizium mit (1, 0, 0)- oder (1, 1, 0)-Orientierung, mit einem Dielektrikum 3 bzw. 4, beispielsweise Siliziumoxid oder Siliziumnitrid (Figur 4a, b).
- Aufbringen einer Galvanik-Startschicht 8, beispielsweise einer Chrom/Gold- oder Titan/Gold-Schicht, auf der Wafervorderseite (Figur 4c).
- Lithographische Übertragung der Geometrie und Anordnung der Ausnehmungen 14 auf eine auf die Galvanik-Startschicht 8 aufgeschleuderte Photolackschicht 5 (Figur 4d).
- Galvanische Abscheidung einer metallischen Schicht 7, insbesondere einer Goldschicht, auf der Wafervorderseite (Figur 4e).
- Entfernen der Photolackschicht 5 (Figur 4f).
- Lithographische Strukturierung der Passivierungsschicht 4 entsprechend der Geometrie der im Halbleitersubstrat 1 zu erzeugenden Durchgangsöffnung 17 (Figur 4g).
- Anisotropes naßchemisches Ätzen des Halbleitersubstrats 1 auf der Waferrückseite (Figur 4h).
- Ätzen der Passivierungsschicht 3 und der Galvanik-Startschicht 8 im Bereich der Substratdurchgangsöffnung 17 (Figur 4e).

## Ansprüche

1. Verfahren zur Herstellung einer Strahlformblende für ein Lithographiegerät, wobei die mit einem primären Teilchenstrahl (15) beaufschlagte Strahlformblende eine Halbleitermembran (2) mit Ausnehmungen (14) zur Erzeugung einer Vielzahl von Teilchensonden (16) aufweist, **dadurch gekennzeichnet,**
- daß eine Halbleiterschicht (2) eines ersten Leitfähigkeitstyps auf einem Halbleitersubstrat (1) eines zweiten Leitfähigkeitstyps abgeschieden wird,
- daß die Halbleiterschicht (2) mit einer ersten dielektrischen Schicht (3) und das Halbleitersubstrat (1) rückseitig mit einer zweiten dielektrischen Schicht (4) versehen wird,
- daß die erste dielektrische Schicht (3) entsprechend der Geometrie und Anordnung der zu erzeugenden Ausnehmungen (14) strukturiert wird,
- daß die zweite dielektrische Schicht (4) entsprechend der Geometrie einer im Halbleitersubstrat (1) zu erzeugenden Durchgangsöffnung (17) strukturiert wird,
- daß die Halbleiterschicht (2) in einem Ätzprozeß durchstossen wird,
- daß die Durchgangsöffnungen (17) durch anisotropes Ätzen des Halbleitersubstrats (1) erzeugt wird,
- daß die dielektrischen Schichten (3, 4) entfernt werden
- und daß die Halbleiterschicht (2) und das Halbleitersubstrat (1) mit einer Metallisierung (7) versehen werden.

2. Verfahren zur Herstellung einer Strahlformblende für ein Lithographiegerät, wobei die mit einem primären Teilchenstrahl (15) beaufschlagte Strahlformblende eine Halbleitermembran (2) mit Ausnehmungen (14) zur Erzeugung einer Vielzahl von Teilchensonden (16) aufweist, **dadurch gekennzeichnet,**
- daß eine Halbleiterschicht (2) eines ersten Leitfähigkeitstyps auf einem Halbleitersubstrat (1) eines zweiten Leitfähigkeitstyps abgeschieden wird,
- daß die Halbleiterschicht (2) mit einer ersten dielektrischen Schicht (3) und das Halbleitersubstrat (1) mit einer zweiten dielektrischen Schicht (4) versehen wird,
- daß die erste dielektrische Schicht (3) entsprechend der Geometrie und Anordnung der zu erzeugenden Ausnehmungen (14) strukturiert wird,

- daß die Halbleiterschicht (2) in einem Ätzprozeß durchstossen wird,
- daß eine Passivierungsschicht (9) innerhalb der Ätzgruben abgeschieden wird,
- daß ein Fenster (10) in der ersten dielektrischen Schicht (3) erzeugt wird,
- daß die zweite dielektrische Schicht (4) entsprechend der Geometrie einer im Halbleitersubstrat (1) zu erzeugenden Durchgangsöffnung (17) strukturiert wird,
- daß die erste dielektrische Schicht (3) mit einer ersten Metallschicht (11) versehen wird,
- daß ein elektrischer Kontakt (12) durch lithographische Strukturierung der ersten metallischen Schicht (11) erzeugt wird,
- daß die Durchgangsöffnung (17) durch anisotropes Ätzen des Halbleitersubstrats (1) unter Verwendung eines elektrochemischen Ätzstops erzeugt wird, wobei die Halbleiterschicht (2) über den elektrischen Kontakt (12) mit einem Pol einer Spannungsquelle verbunden ist,
- daß die dielektrischen Schichten (3, 4) und der elektrische Kontakt (12) entfernt werden,
- und daß die Halbleiterschicht (2) und das Halbleitersubstrat (1) mit einer zweiten metallischen Schicht (7) versehen werden.

3. Verfahren zur Herstellung einer Strahlformblende für ein Lithographiegerät, wobei die mit einem primären Teilchenstrahl (15) beaufschlagte Strahlformblende eine Halbleitermembran (2) mit Ausnehmungen (14) zur Erzeugung einer Vielzahl von Teilchensonden (16) aufweist, **dadurch gekennzeichnet,**
- daß ein Halbleiterkörper (1) vorderseitig mit einer ersten dielektrischen Schicht (3) und rückseitig mit einer zweiten dielektrischen Schicht (4) versehen wird,
- daß eine erste metallische Schicht (8) auf der ersten dielektrischen Schicht (3) aufgebracht wird,
- daß die Geometrie und Anordnung der zu erzeugenden Ausnehmungen (14) auf eine auf die erste metallische Schicht (8) aufgebrachte Photolackschicht (5) übertragen wird,
- daß eine zweite metallische Schicht (7) auf der ersten metallischen Schicht (8) galvanisch abgeschieden wird,
- daß die Photolackschicht (5) entfernt wird,
- daß die zweite dielektrische Schicht (4) entsprechend der Geometrie einer im Halbleitersubstrat (1) zu erzeugenden Durchgangsöffnung (17) strukturiert wird,
- daß das Halbleitersubstrat (1) einem anisotropen Ätzprozeß unterworfen wird,
- und daß die erste dielektrische Schicht (3) und die ersten metallischen Schicht (8) im Bereich der Durchgangsöffnung (17) entfernt werden.

4. Verfahren nach Anspruch 1, 2 oder 3, **dadurch gekennzeichnet,** daß das Halbleitersubstrat (1) aus Silizium besteht, wobei das Silizium eine (1, 0, 0)-Orientierung aufweist.

5. Verfahren nach Anspruch 1, 2 oder 3, **dadurch gekennzeichnet,** daß das Halbleitersubstrat (1) aus Silizium besteht, wobei das Silizium eine (1, 1, 0)-Orientierung aufweist.

# FIG 1

**FIG 2**

# FIG 2

f)

g)

h)

i)

FIG 3

# FIG 3

g)

h)

i)

j)

k)

l)

## FIG4

a) 1

b) 3 1 4

c) 8 3 1 4

d) 5 8 3 1 4

e) 5 7 8 3 1 4

f) 7 8 3 1 4

# FIG 4

g)

7
8
3
1
4

h)

7
8
3
1
4

17

i)

7
8
3
1

17